Europäisches Patentamt

(19) European Patent Office

Office européen des brevets

(11) Numéro de publication : **0 122 823**
**B1**

(12) **FASCICULE DE BREVET EUROPÉEN**

(45) Date de publication du fascicule du brevet :
16.06.87

(51) Int. Cl.⁴ : **E 21 B  7/04**, E 21 B 17/16,
E 21 B 47/022,
G 01 R 33/025

(21) Numéro de dépôt : 84400433.3

(22) Date de dépôt : 05.03.84

(54) **Dispositif de compensation automatique du magnétisme des garnitures de forage.**

(30) Priorité : 13.03.83 FR 8304036

(43) Date de publication de la demande :
24.10.84 Bulletin 84/43

(45) Mention de la délivrance du brevet :
16.06.87 Bulletin 87/25

(84) Etats contractants désignés :
DE GB IT

(56) Documents cités :
FR-A- 1 485 557
FR-A- 2 060 261
FR-A- 2 126 981
GB-A- 1 474 751
GB-A- 2 070 105
US-A- 2 735 063
US-A- 3 406 766
US-A- 3 731 752

(73) Titulaire : **COMMISSARIAT A L'ENERGIE ATOMIQUE**
**Etablissement de Caractère Scientifique Technique**
**et Industriel**
**31/33, rue de la Fédération**
**F-75015 Paris (FR)**

(72) Inventeur : **Chiron, Guy**
**Les Cèdres**
**F-38610 Gieres (FR)**
Inventeur : **Vidal, Jean-Charles**
**26, rue du Pre d'Elle**
**F-38240 Meylan (FR)**

(74) Mandataire : **Mongrédien, André et al**
**c/o BREVATOME 25, rue de Ponthieu**
**F-75008 Paris (FR)**

EP 0 122 823 B1

## Description

La présente invention se rapporte aux techniques de forage des puits dans le sous-sol et plus particulièrement au cas où la cavité de forage doit être constituée, au moins en partie, de zones ayant une certaine courbure.

Dans ce cas particulier, il est parfois nécessaire de guider l'outil de forage dans les zones courbes en utilisant un repérage effectué à l'aide de mesures magnétiques par rapport à la direction et à l'intensité du champ magnétique terrestre. Lorsque le forage a lieu dans des parties à fortes courbures, on utilise habituellement des garnitures de forage constituées par des barres cylindriques pleines ou creuses d'une longueur de 20 à 50 m par exemple, pour pousser l'outil de coupe dans la cavité de forage. Malheureusement, le moteur de l'outil ainsi que les garnitures de forage chargées d'assurer sa progression sont en général en des matériaux fortement ferromagnétiques comme le fer ou l'acier ordinaire et possèdent de ce fait une aimantation non négligeable. Cette aimantation a le grave défaut de perturber le champ magnétique ambiant et de fausser par conséquent les indications du capteur de positionnement par rapport au champ magnétique terrestre si ce capteur se trouve placé à proximité des garnitures de forage, ce qui est pratiquement nécessaire.

Pour lutter contre cette difficulté, on a adopté jusqu'à ce jour une solution qui consiste à utiliser l'acier inoxydable non magnétique pour constituer celles des garnitures de forage qui sont les plus proches du capteur de positionnement (voir GB-A-2 070 105). Malheureusement, ce métal est très cher et cette solution n'est pas, de ce fait, idéale.

La présente invention a précisément pour objet un dispositif de compensation automatique du magnétisme des garnitures de forage qui permet de compenser l'effet magnétique nuisible de ces garnitures au niveau même des capteurs de champ magnétique commandant le positionnement de l'outil de forage et ce, à l'aide de moyens dont la mise en œuvre est simple et peu coûteuse. Ce dispositif de compensation automatique du magnétisme des garnitures de forage du genre de celles qui sont constituées par des barres cylindriques pleines ou creuses en matériau magnétique pour pousser, par gravité, l'outil de forage ledit outil de forage étant guidé dans sa progression à l'aide des indications d'un capteur de positionnement par rapport au champ magnétique terrestre, se caractérise en ce que chaque extrémité des garnitures entourant le capteur de positionnement est munie d'une bobine parcourue par un courant dont l'intensité est réglée automatiquement, en fonction des indications du capteur, pour rendre nuls, dans la zone du capteur, le gradient du champ magnétique dû aux garnitures et ce champ lui-même.

On voit donc que le dispositif objet de l'invention, qui n'utilise qu'une courte bobine placée aux extrémités des deux garnitures les plus proches du capteur, permet d'aimanter en sens inverse de l'aimantation induite par le champ terrestre cette partie du matériau constituant les garnitures, de telle sorte qu'il existe, au voisinage de ces mêmes extrémités, une zone où le gradient de champ magnétique dû aux garnitures est nul. Si l'on choisit de plus, judicieusement la longueur de la bobine, la position du point de mesure du champ, c'est-à-dire celle du capteur par rapport à la garniture et l'intensité du courant qui traverse la bobine, on peut également obtenir facilement que le champ perturbateur soit nul au point où se trouve situé le capteur de positionnement. On obtient ainsi par conséquent que le champ magnétique dû aux garnitures et le gradient de ce champ soient nuls dans la zone du capteur.

Selon une variante intéressante de la présente invention, le capteur de positionnement se compose, dans un manchon cylindrique creux en matériau amagnétique, de deux sondes magnétiques situées à une distance x de l'extrémité de la garniture et à une distance $\Delta x$ l'une de l'autre, d'un amplificateur différentiel établissant la différence des indications fournies par les deux sondes et commandant à l'aide de cette différence un générateur de courant qui règle l'intensité parcourant la bobine à une valeur telle que le gradient du champ magnétique dû aux garnitures et ce champ lui-même soient nuls à la distance x de ladite garniture.

Conformément à l'invention, on utilise donc le gradient de champ magnétique entre les deux sondes magnétiques voisines l'une de l'autre pour régler automatiquement le courant traversant la bobine et c'est alors, par construction, que le champ perturbateur est, de ce fait, rendu nul en ce point. Ce résultat une fois atteint on est alors certain que les indications du capteur de positionnement de l'outil de forage ne sont plus perturbées par rapport au champ terrestre et l'on peut les utiliser pour commander la progression de l'outil de forage dans la direction souhaitée pour la cavité.

De toute façon l'invention sera mieux comprise à la lecture qui suit de plusieurs exemples de mise en œuvre du dispositif de compensation automatique, description qui sera faite en se référant aux figures 1 à 4 suivantes sur lesquelles :

la figure 1 représente schématiquement dans un puits de forage ayant une certaine courbure, la position des garnitures entourant le capteur de positionnement magnétique et poussant l'engin de forage ;

la figure 2 représente très schématiquement le dispositif de compensation automatique objet de l'invention dans le cas où celui-ci est placé à l'extrémité de la dernière garniture précédant l'outil de forage ;

la figure 3 représente schématiquement le dispositif de compensation automatique objet de l'invention dans le cas où il est situé aux deux extrémités de deux garnitures voisines entourant le capteur de positionnement magnétique ;

la figure 4 représente plus en détail le mode de réalisation de la figure 2.

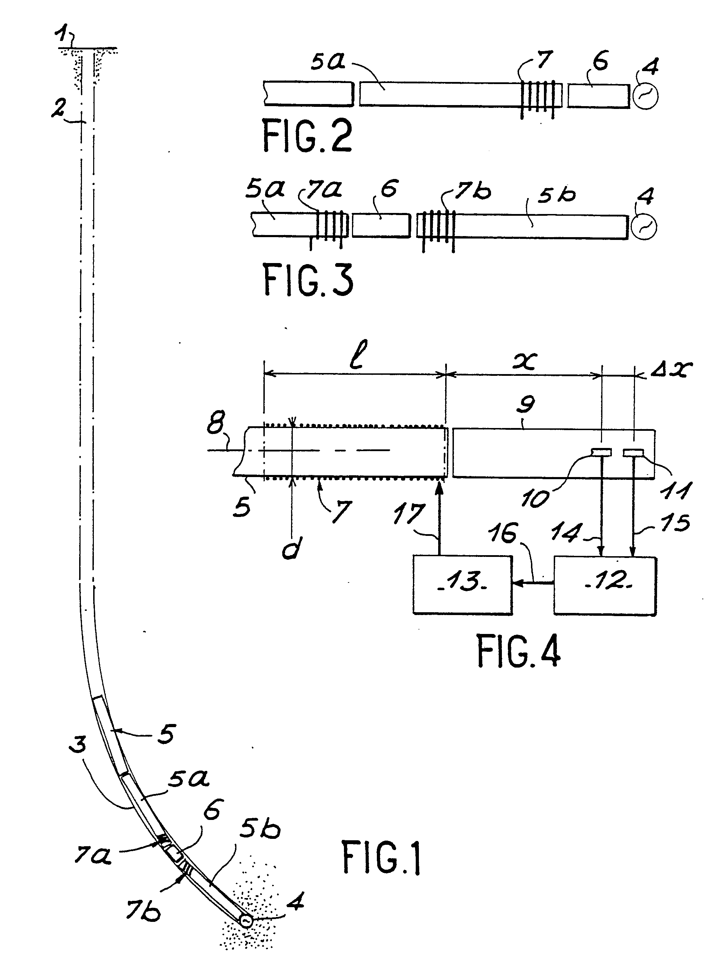

Sur la figure 1 on a représenté la surface du sol 1 et le puits de forage 2 qui acquiert une certaine courbure sur le trajet 3. Dans ce puits de forage 2, se trouve l'outil de forage 4 qui peut être par exemple un trépan ou tout outil équivalent. Comme expliqué précédemment l'outil 4 est précédé, dans le canal de forage 2, par un certain nombre de garnitures 5 (ici au nombre de trois) qui sont en fait des barres pleines ou creuses en fer ou acier ordinaire magnétique d'une longueur de 20 à 50 mètres et d'un diamètre de l'ordre de 20 cm permettant leur passage de façon compatible avec la courbure de la région 3 du puits de forage. Ces garnitures dont le poids est considérable ont essentiellement pour but d'appuyer sur l'outil de forage 4 en le poussant par gravité. Entre les garnitures 5a et 5b, se trouve placé le capteur de positionnement 6 qui permet d'orienter la progression de l'outil 4 en se repérant dans l'espace par rapport à la direction du champ magnétique terrestre au point où il est placé. Conformément à l'invention, les extrémités des garnitures 5a et 5b voisines du capteur de positionnement, sont munies chacune d'une bobine à savoir respectivement 7a et 7b parcourues par un courant dont l'intensité est réglée automatiquement en fonction des indications du capteur 6 pour rendre nuls dans la zone de ce capteur 6 à la fois le champ magnétique dû aux garnitures et son gradient. De cette façon on est assuré que le capteur de positionnement 6 ne subit plus aucune perturbation dans son repérage par rapport au champ magnétique terrestre de la part des garnitures voisines 5a et 5b. On expliquera en détail plus loin en se référant à la figure 4, la façon dont le capteur de positionnement 6 règle les courants parcourant les bobines 7a et 7b pour parvenir à ce résultat.

Sur la figure 2, on a représenté un exemple de mise en œuvre du dispositif objet de l'invention dans lequel le capteur de positionnement 6 est directement placé entre l'outil de forage 4 et la garniture adjacente 5a. Dans ce cas particulier, une seule bobine 7 est prévue à l'extrémité de la garniture 5a au voisinage du capteur 6.

Sur la figure 3, on a représenté un autre mode de mise en œuvre qui correspond à celui de la figure 1 dans lequel le capteur 6 est inséré entre les garnitures adjacentes 5a et 5b, l'outil de forage 4 étant en tête du dispositif à l'extrémité de la garniture 5b qui ne contient pas d'enroulement. On retrouve sur cette figure les deux enroulements 7a et 7b de la figure 1.

Sur la figure 4, on a représenté plus en détail le schéma d'un dispositif de compensation automatique objet de l'invention, qui comporte selon l'axe de forage 8 l'extrémité d'une garniture 5, une bobine 7 et un manchon cylindrique creux 9 en matériau amagnétique qui contient les deux sondes 10 et 11 détectrices du champ magnétique local. La sonde 10 est à une distance x de l'extrémité la plus proche de la garniture 5 et l'écart entre les sondes 10 et 11 est de $\triangle$x. Pour préciser davantage les grandeurs réciproques des éléments en présence, on se référera à un exemple dans lequel la garniture 5 ayant un diamètre de 20 cm, la bobine 7 a un diamètre de 25 cm et dans lequel la distance x est de 55 cm pour une bobine 7 de 80 cm de longueur. Dans cet exemple, le deuxième capteur 11 est situé à 5 cm du premier capteur 10, ce qui revient à dire qu'une valeur moyenne pour le rapport $\triangle$x/x est de l'ordre de 1/10è. Le positionnement des deux capteurs 10 et 11 l'un par rapport à l'autre, est assuré par le tube creux en matériau amagnétique 9 qui joue le même rôle que la garniture non magnétique habituellement utilisée dans l'art antérieur pour éloigner le capteur de positionnement du champ magnétique produit par les garnitures de forage 5, mais il est ici d'une dimension beaucoup plus courte, sa longueur étant par exemple de l'ordre de 1 m au lieu des 20 m habituels de ce type de garniture. En fait, sa longueur dépend de la cote x séparant le premier capteur 10 de l'extrémité de la garniture 5, laquelle est elle-même fonction de la longueur 1 de la bobine 7. Sur cette figure 4, l'outil de forage n'a pas été représenté.

A l'intérieur du manchon cylindrique creux 9 se trouvent situés également l'amplificateur différentiel 12 et la commande de générateur de courant 13 que l'on a représentés sur le dessin, pour plus de clarté, extérieurs au manchon 9. L'amplificateur différentiel 12 reçoit par les deux connexions 14 et 15 les indications respectives des capteurs 10 et 11 et il établit leur différence qu'il amplifie. Cette différence est ensuite transmise par la ligne 16 à la commande de générateur de courant 13 qui alimente les spires de la bobine 7 par l'intermédiaire du conducteur 17. L'amplificateur différentiel 12 se comporte donc en fait comme un détecteur de zéro, c'est-à-dire qu'il stabilise le courant envoyé par le générateur 13 dans la bobine 7 à une valeur constante dès lors que les indications reçues sur les lignes 14 et 15 sont les mêmes. La sonde 10 fournit alors la valeur axiale du champ magnétique terrestre devenu rigoureusement indépendant de toute influence magnétique due aux garnitures 5 ou à l'outil de forage.

La source d'énergie nécessaire au fonctionnement du système peut être soit une pile, soit un accumulateur situé à l'intérieur du manchon cylindrique creux 9, soit même à l'extérieur du forage.

## Revendications

1. Dispositif de compensation automatique du magnétisme des garnitures de forage, du genre de celles qui sont constituées par des barres cylindriques (5) pleines ou creuses en matériau magnétique pour pousser, par gravité, l'outil de forage (4), ledit outil de forage (4) étant guidé dans sa progression à l'aide des indications d'un capteur de positionnement (6) par rapport au champ magnétique terrestre, caractérisé en ce que chaque extrémité des garnitures (5) entourant le capteur de positionnement (6) est munie d'une bobine (7) parcourue par un courant dont l'intensité est réglée automatiquement en fonction des indications du capteur pour rendre nuls dans la zone du capteur, le gradient du champ magnétique dû aux garnitures (5) et ce champ lui-même.

2. Dispositif de compensation automatique selon la revendication 1, caractérisé en ce que le capteur de positionnement (6) se compose, dans un manchon cylindrique creux (9) en matériau amagnétique, de deux sondes magnétiques (10, 11) situées à une distance x de l'extrémité de la garniture (5) et à une distance △x l'une de l'autre, d'un amplificateur différentiel (12) établissant la différence des courants fournis par les deux sondes (10, 11) et commandant à l'aide de cette différence un générateur de courant (13) qui règle l'intensité parcourant la bobine (7) à une valeur telle que le champ magnétique dû aux garnitures (5) et son gradient soient nuls à la distance x de ladite garniture.

3. Dispositif de compensation automatique selon la revendication 2, caractérisé en ce que l'une des deux sondes magnétiques est un capteur à trois axes orientés selon un trièdre trirectangle et dont l'un des axes est dirigé selon l'axe de la garniture.

**Claims**

1. Device for the automatic compensation of the magnetism of drilling sets, of the type of those which consist of solid or hollow cylindrical bars (5) of magnetic material to push, by gravity, the drilling tool (4), the said drilling tool (4) being guided in its progress with the aid of the indications of a position sensor (6) in relation to the magnetic field of the earth, characterized in that each end of the sets (5) surrounding the position sensor (6) is equipped with a coil (7), through which a current flows, the intensity of which is automatically regulated as a function of the indications of the sensor to render zero, in the zone of the sensor, the gradient of the magnetic field due to the sets (5) and this field itself.

2. Automatic compensation device according to Claim 1, characterized in that the position sensor (6) is composed, in a hollow cylindrical sleeve (9) of non-magnetic material, of two magnetic probes (10, 11) situated at a distance x from the end of the set (5) and at a distance △x from one another, and of a differential amplifier (12) forming the difference of the currents supplied by the two probes (10, 11) and controlling, with the aid of this difference, a current generator (13) which regulates the current intensity flowing through the coil (7) at a value such that the magnetic field due to the sets (5) and its gradient are zero at the distance x from the said set.

3. Automatic compensation device according to Claim 2, characterized in that one of the two magnetic probes is a sensor having three axes oriented according to a trirectangular trihedron and one of the axes of which is directed along the axis of the set.

**Patentansprüche**

1. Automatische Kompensationsvorrichtung für den magnetischen Einfluß auf Schwerstangen, die aus hohlen oder massiven zylindrischen Gliedern (5) aus magnetischem Material bestehen um das Bohrwerkzeug (4) mittels Schwerkraft vorzudrücken, wobei das Fortschreiten des Bohrwerkzeugs (4) mittels Anzeigen eines Positionsfühlers (6) bezüglich des magnetischen Erdfeldes gesteuert wird, dadurch gekennzeichnet, daß jedes Ende der den Positionsfühler (6) umgebenden Stangen (5) mit einer Spule (7) versehen ist, die von einem Strom durchflossen wird, dessen Stärke automatisch als Funktion der Anzeigen des Fühlers derart geregelt wird, daß der Gradient des magnetischen Feldes aufgrund der Stangen (5) und des Feldes selbst im Bereich des Fühlers Null wird.

2. Automatische Kompensationsvorrichtung nach Anspruch 1, dadurch gekennzeichnet, daß der Positionsfühler (6) aus zwei in einer hohlen zylindrischen Hülle (9) aus nichtmagnetischem Material angeordneten magnetischen Sonden (10, 11) besteht, die in einem Abstand (X) vom Ende der Stange (5) und in einem Abstand (△X) voneinander angeordnet sind und aus einem Differenzverstärker (12) besteht, der die Differenz der von den beiden Sonden (10, 11) gelieferten Ströme feststellt und mittels dieser Differenz einen Stromgenerator (13) steuert, der die Stärke des die Spule (7) durchfließenden Stromes regelt auf einen derartigen Wert, daß das magnetische Feld aufgrund der Stangen (5) und dessen Gradienten im Abstand (X) von der Stange Null wird.

3. Automatische Kompensationsvorrichtung nach Anspruch 2, dadurch gekennzeichnet, daß eine der beiden magnetischen Sonden ein Fühler mit drei Achsen ist, die gemäß einem orthogonalen Dreibein ausgerichtet sind, wobei eine der Achsen in der Achse der Stange liegt.

FIG.2

FIG.3

FIG.4

FIG.1